# EUROPEAN PATENT APPLICATION

(11) **EP 2 333 439 A2**
(43) Date of publication of application: **15.06.2011**
(21) Application number: 10193319.0
(22) Date of filing: 01.12.2010
(51) Int. Cl.: F24F 3/06, F24F 11/00, F24F 11/053, H05K 7/20

(54) **Cooling method and cooling system of electronic device**

(30) Priority: 01.12.2009 JP 2009273488; 18.02.2010 JP 2010033666
(71) Applicant: Hitachi Plant Technologies, Ltd., Toshima-ku Tokyo 170-8466 (JP)
(72) Inventor: Kashirajima, Yasuhiro, Tokyo 170-8466 (JP); Ito, Junichi, Tokyo 170-8466 (JP); Inadomi, Yasuhiko, Tokyo 170-8466 (JP); Sugiura, Takumi, Tokyo 170-8466 (JP); Shimokawa, Ryoji, Tokyo 170-8466 (JP); Senda, Masakatsu, Tokyo 170-8466 (JP); Oshima, Noboru, Tokyo 170-8466 (JP)
(74) Representative: Beetz & Partner

(57) **Abstract**

Even when the flow rate of a cooling medium of evaporators in a cooling system of a cooling-medium natural-circulation method is subjected to valve control, the natural circulation of the cooling medium can be stably maintained, and formation of dew on the surfaces of the evaporators can be prevented. In a cooling method of electronic devices of naturally circulating a cooling medium between evaporators (20X) and (20Y), which gasifies the cooling medium and cools heat-discharging air from servers (14) by heat exchange with the heat-discharging air, and a cooling tower (22), which is disposed at a higher position than the evaporators (20X) and (20Y) and liquefies the gasified cooling medium, and subjecting the flow rate of the cooling-medium liquid supplied to the evaporators (20X) and (20Y) to valve control so that the temperature of the air obtained after the heat exchange and the cooling by the evaporators (20X) and (20Y) becomes a temperature suitable for the operating environments of the servers (14), the condensation temperature or the condensation pressure of the cooling-medium gas in a cooling tower (22) is configured not to be varied even when the flow rate of the cooling-medium liquid supplied to the evaporators (20X) and (20Y) is subjected to valve control.

## Description

### BACKGROUND OF THE INVENTION

### Field of the Invention

The present invention relates to a cooling method and a cooling system of electronic devices and, particularly, relates to a cooling method and a cooling system of electronic devices for locally cooling the electronic devices such as computers or servers disposed in a server room by naturally circulating a cooling medium between evaporators and a cooling tower (or condenser).

### Description of the Related Art

In a server room, many electronic devices such as computers or servers are installed in the state in which the electronic devices are gathered. The electronic devices are installed generally by a rack-mount method, i.e., a method in which the racks (chassis) separating the electronic devices by functional units and housing the devices are stacked in cabinets; and many such cabinets are disposed to be aligned on the floor.

These electronic devices require a constant temperature environment for carrying out normal operations; and, when the electronic devices are in a high-temperature state, troubles such as system halt may be caused. Therefore, the server room is controlled to be in a constant temperature environment by an air conditioner. However, recently, along with the rapid increase in the processing speed and processing ability of the electronic devices, the amount of the heat generated from the electronic devices is steadily increasing, and the running cost of the air conditioner is also increasing significantly.

Because of such a background, various techniques for efficiently cooling the electronic devices have been proposed. For example, in Japanese Patent Publication No. 2006-507676, a method that locally cools electronic devices by forming a closed loop current through the electronic devices and cooling the closed loop current by a heat exchanger is proposed.

A method in which the server room is cooled by floor blow-out air conditioning using a package air conditioner has been also carried out. However, this method has a problem that cooling efficiency is bad since the entire server room is subjected to air conditioning in order to suppress the local temperature increase that is caused by the heat discharged from the electronic devices. Therefore, the air-blowing power required for transfer of heat accounts for a large share of air-conditioning power. Therefore, a method for how to reduce the heat-transferring power is important for energy-saving measures.

Therefore, cooling systems using the methods in which a cooling medium is naturally circulated as shown in Japanese Patent Application Laid-Open No. 1-121641 and Japanese Patent Application Laid-Open No. 2007-127315 have been proposed. Japanese Patent Application Laid-Open No. 1-121641 proposes to save energy by providing flow-rate adjusting valves for evaporators, respectively, so that each of the evaporators can manage an individual heat load, controlling the supply amount of the cooling-medium liquid supplied to the evaporators by the valves, and individually adjusting the abilities of the evaporators. When the supply amount of the cooling-medium liquid supplied to the evaporators is subjected to valve control in this manner, the high-temperature heat-discharging air from servers can be appropriately cooled by the evaporators and released to a server room. As a result, the server room is controlled to a set temperature condition.

The cooling system of Japanese Patent Application Laid-Open No. 2007-127315 is composed by mutually connecting an evaporator and a condenser, which is at an altitude higher than that of the evaporator, by gas piping and liquid piping. The cooling-medium gas gasified by the evaporator is sent to the condenser via the gas piping, and the cooling-medium liquid liquefied by the condenser is sent to the evaporator via the liquid piping; as a result, the cooling medium can be naturally circulated, and a cooling action can be obtained by the evaporator. When a cooling system of such a cooling-medium natural-circulation type is applied to local cooling of servers, reduction in the running cost can be expected. In this case, the running cost can be significantly reduced by installing a cooling tower on the rooftop of a building as the condenser and cooling the cooling medium by the cooling tower by utilizing outside air.

Examples that use a condenser of a cooling tower type include Japanese Patent No. 3990161, wherein an ammonia cooling unit that forms a refrigeration cycle including a compressor, an evaporative condenser serving as a condenser, an expansion valve, and an evaporator by using an ammonia cooling medium is described. The evaporative condenser condenses a cooling-medium gas into a cooling-medium liquid by utilizing outside air and water sprinkling.

However, the cooling systems of the cooling-medium natural-circulation method have below problems to be solved.
(1) In the cooling system of the cooling-medium natural-circulation type, in the case in which the flow rate of the cooling medium that flows to the evaporator is subjected to valve control, the valve control has the mechanism that adjusts the flow rate of the cooling medium by changing the piping resistance of the piping in which the cooling medium flows. Therefore, in the cooling-medium natural-circulation method in which the operating state of the cooling system is largely affected by the piping resistance, there is a problem that variations in the evaporation temperature are caused by the valve control. For example, in some cases, the evaporation pressure in the evaporator is reduced by the valve control, leading to reduction in the evaporation temperature beyond necessity, and the temperature at the outlet of the evaporator is significantly reduced. Due to the significant reduction in the temperature at the outlet of the evaporator, dew may be formed on the surface of the evaporator. When the dew is formed on the surface of the evaporator, the dew adversely affects the electronic devices and lowers reliability, and, in addition to that, there is a problem that energy is lost for preventing the dew.

Furthermore, in the case in which the cooling medium is naturally circulated between the evaporator and the cooling tower (or condenser), appropriately maintaining the difference in the pressures between the cooling-medium condensing side (cooling tower or condenser side) of the low-pressure side and the cooling-medium evaporation side (evaporator side) of the high-pressure side is important for stabilizing the natural circulation, and the condensation pressure and the evaporation pressure are linked to the condensation temperature and the evaporation temperature. Therefore, when the evaporation temperature is varied, the evaporation pressure is also varied; therefore, there is a problem that the natural circulation of the cooling medium is not stabilized.
(2) In the evaporative converter of Japanese Patent No. 3990161, when the outside air temperature is lowered, the condensation pressure at which the cooling-medium gas is condensed by a heat-exchanging coil is reduced. Therefore, the cooling-medium liquid remains at the heat-exchanging coil in the evaporative condenser, and the amount of the cooling medium supplied to the evaporator is reduced; therefore, there is a problem that the cooling ability of the evaporator is reduced. Particularly, in the case in which the cooling medium is naturally circulated between the evaporator and the condenser, when the cooling-medium liquid remains in the heat-exchanging coil of the evaporative condenser, the liquid column that serves as the drive force of the natural circulation in the liquid piping is lowered; therefore, the cooling-medium liquid is not supplied to the evaporator, and the cooling ability of the evaporator is reduced.

Therefore, during the winter when the outside air temperature is lowered, the heat quantity in the evaporative condenser has to be controlled, and a method in which the volume of the outside air taken in by an air blower is reduced is conceivable. However, when the outside air temperature is lowered, the temperature of the outside air that contacts the heat-exchanging coil remains low even when the air volume is reduced; therefore, the condensation pressure is reduced. Also, reducing the sprinkle water amount of the water sprinkled from a water sprinkler to the heat-exchanging coil is conceivable; however, when the outside air temperature is low, this method is not effective to heat quantity control almost at all.

The present invention has been accomplished in view of the foregoing circumstances, and it is an object of the present invention to provide a cooling method and a cooling system of electronic devices capable of stably maintaining natural circulation of a cooling medium and preventing formation of dew on the surfaces of evaporators even when the cooling-medium flow rate of the evaporators is subjected to valve control in the cooling system of the cooling-medium natural-circulation method.

The present invention has been accomplished in the foregoing circumstances, and it is also an object of the present invention to provide a cooling system capable of preventing reduction in the cooling ability of evaporators by preventing the condensation pressure from being reduced more than necessity by simple structural improvement of a cooling tower even during the winter when the outside air temperature is low, in the case in which the cooling tower serves as a condenser and a cooling medium is circulated, particularly, naturally circulated between the condenser and the evaporators.

### SUMMARY OF THE INVENTION

In order to achieve the objects, a first aspect of the present invention provides a cooling method of an electronic device, the cooling method naturally circulating a cooling medium between an evaporator, which gasifies the cooling medium and cools heat-discharging air from the electronic device by heat exchange with the heat-discharging air, and a cooling tower or a condenser, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, wherein a condensation temperature or a condensation pressure of the cooling-medium gas in the cooling tower or the condenser is configured to be not varied even when the flow rate of the cooling-medium liquid supplied to the evaporator is subjected to the valve control.

According to the first aspect of the present invention, the condensation temperature or the condensation pressure of the cooling-medium gas in the cooling tower or the condenser in the low-pressure side of the cooling system is configured to be not varied even when the flow rate of the cooling-medium liquid supplied to the evaporator is subjected to valve control. When the condensation temperature or the condensation pressure of the cooling tower side or the condenser side is controlled not to be varied in this manner in parallel with the valve control in the evaporator side, the variation in the evaporation pressure in the evaporator side is suppressed. As a result, the natural circulation of the cooling medium can be stably maintained, and formation of dew on the surface of the evaporator can be prevented.

The evaporation pressure in the evaporator of the cooling-medium natural-circulation method is controlled by the condensation pressure at the condenser and the difference in the height between the evaporator and the condenser. In other words, an equation: evaporator internal pressure = condensation pressure + head differential pressure is satisfied. Therefore, when the head differential pressure is constant, the evaporator internal pressure is varied depending on variation in the condensation pressure. Therefore, the natural circulation of the cooling medium can be stably maintained by configuring the condensation pressure of the cooling-medium gas in the cooling tower or the condenser serving as the low-pressure side of the cooling system not to be varied even when the flow rate of the cooling-medium liquid supplied to the evaporator is subjected to valve control. The condensation temperature changes in conjunction with the condensation pressure; therefore, when the condensation temperature is configured not to be varied, the natural circulation of the cooling medium can be stably maintained.

Since the evaporator is disposed below the condenser, the evaporator internal pressure always has a higher value than the condensation pressure. Therefore, when the condenser internal pressure is set to a pressure corresponding to a cooling-medium saturation temperature rather than to a dew point in the room, the evaporation temperature of the evaporator always becomes a temperature equal to or more than the dew point of the air in the room. Therefore, formation of dew on the surface of the evaporator can be prevented.

In order to achieve the objects, a second aspect of the present invention provides a cooling system of an electronic device, the cooling system naturally circulating a cooling medium between an evaporator, which gasifies the cooling medium and cools heat-discharging air from the electronic device by heat exchange with the heat-discharging air, and a cooling tower, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, wherein the cooling tower has: a cooling-tower main body in which an intake opening and a discharge opening of outside air are formed; a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows; a sprinkler which sprinkles water to the heat-exchanging coil; an air blower which takes in the outside air from the intake opening, blows the air to the heat-exchanging coil, and causes the air to be discharged from the discharge opening; an air-blow volume adjusting device which adjusts an air-blow volume of the air blower; a cooling-medium liquid temperature sensor which measures a temperature of the cooling-medium liquid at the outlet of the heat-exchanging coil; and a controller which controls the air-blow volume adjusting device based on the temperature measured by the cooling-medium liquid temperature sensor; and the controller controls the air-blow volume of the air blower by the air-blow volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

The second aspect shows a specific device configuration for preventing the condensation temperature of the cooling-medium gas in the cooling tower or the condenser from being varied even when the flow rate of the cooling-medium liquid supplied to the evaporator is subjected to valve control.

According to the second aspect of the present invention, even when the evaporation temperature of the evaporator is varied by subjecting the supply amount of the cooling-medium liquid supplied to the evaporator to valve control, the controller controls the air-blow volume of the air blower, which cools the heat-exchanging coil in the cooling tower serving as the low-pressure side of the cooling system, so that the temperature of the cooling-medium liquid at the outlet of the heat-exchanging coil of the cooling tower is maintained at the predetermined temperature without being varied.

Thus, even when the flow rate of the cooling medium of the evaporator in the cooling system of the cooling-medium natural-circulation method is subjected to valve control, the natural circulation of the cooling medium can be stably maintained, and formation of dew on the surface of the evaporator can be prevented.

In a third aspect of the present invention according to the second aspect, the cooling-medium liquid temperature sensor is replaced by a cooling-medium liquid pressure sensor; and the controller controls the air-blow volume of the air blower by the air-blow volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

In the third aspect, instead of the temperature of the cooling-medium liquid at the outlet of the heat-exchanging coil, the condensation pressure at the outlet of the heat-exchanging coil is controlled to become the predetermined pressure.

In order to achieve the objects, a fourth aspect of the present invention provides a cooling system of an electronic device, the cooling system naturally circulating a cooling medium between an evaporator, which gasifies the cooling medium and cools heat-discharging air from the electronic device by heat exchange with the heat-discharging air, and a cooling tower, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, wherein the cooling tower has: a cooling-tower main body in which an intake opening and a discharge opening of outside air are formed; a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows; a sprinkler which sprinkles water to the heat-exchanging coil; an air blower which takes in the outside air from the intake opening, blows the air to the heat-exchanging coil, and causes the air to be discharged from the discharge opening; a cooling-medium liquid temperature sensor which measures a temperature of the cooling-medium liquid at the outlet of the heat-exchanging coil; a circulation duct which returns part of discharge outside-air, which is discharged from the discharge opening, to a vicinity of the intake opening and mixes the returned outside-air with the outside air taken in from the intake opening; a circulated air-volume adjusting device which adjusts an air volume of the discharge outside-air flowing in the circulation duct; and a controller which controls the circulated air-volume adjusting device based on the temperature measured by the cooling-medium liquid temperature sensor; and the controller controls the circulated air-volume of the discharge outside-air flowing in the circulation duct by the circulated air-volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

The fourth aspect is another mode showing a specific device configuration for preventing the condensation temperature of the cooling-medium gas in the cooling tower from being varied even when the flow rate of the cooling-medium liquid supplied to the evaporator is subjected to valve control.

According to the fourth aspect of the invention, even when the evaporation temperature of the evaporator is varied by subjecting the supply amount of the cooling-medium liquid supplied to the evaporator to valve control, the controller controls the circulated air-volume of the discharge outside-air circulated through the circulation duct so that the temperature of the cooling-medium liquid at the outlet of the heat-exchanging coil of the cooling tower is maintained at the predetermined temperature without being varied in conjunction with the variation. More specifically, when the circulation duct is provided, part of the discharge outside-air having a temperature increased by the heat exchange at the heat-exchanging coil is returned to the vicinity of the intake opening of the cooling-tower main body, and the returned air is mixed with the intake outside air taken in from the intake opening. As a result, the temperature of the air blown to the heat-exchanging coil is changed. The temperature of the blown air can be also adjusted by adjusting the volume of the circulated air of the circulation duct. As a result, the condensation temperature in the cooling tower, which is the low-pressure side of the cooling system, can be maintained constantly at the predetermined temperature.

Therefore, even when the flow rate of the cooling medium of the evaporator in the cooling system of the cooling-medium natural-circulation method is subjected to valve control, the natural circulation of the cooling medium can be stably maintained, and formation of dew on the surface of the evaporator can be prevented.

In a fifth aspect of the present invention according to the fourth aspect, the cooling-medium liquid temperature sensor is replaced by a cooling-medium liquid pressure sensor; and the controller controls the circulated air-volume of the discharge outside-air flowing in the circulation duct by the circulated air-volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

In the fifth aspect, instead of the temperature of the cooling-medium liquid at the outlet of the heat-exchanging coil, the condensation pressure at the outlet of the heat-exchanging coil is controlled so as to become the predetermined pressure.

In order to achieve the objects, a sixth aspect of the present invention provides a cooling system of an electronic device, the cooling system naturally circulating a cooling medium between an evaporator, which gasifies the cooling medium and cools heat-discharging air from the electronic device by heat exchange with the heat-discharging air, and a cold-water type condenser, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, wherein the cold-water type condenser is a condenser which has an inlet and an outlet and obtains cold energy for condensing the cooling-medium gas into the cooling-medium liquid by cold water supplied to the cold-water type condenser via cold-water supply piping, the inlet connected to gas piping in which the cooling-medium gas returning from the evaporator flows, the outlet connected to liquid piping in which the cooling-medium liquid supplied to the evaporator flows; the condenser having a cold-water volume adjusting device which is provided at the cold-water supply piping and adjusts a flow rate of the cold water supplied to the cold-water type condenser; a cooling-medium liquid temperature sensor which measures a temperature of the cooling-medium liquid at the outlet of the cold-water type condenser; and a controller which controls the cold-water volume adjusting device based on the temperature measured by the cooling-medium liquid temperature sensor; and the controller controls the flow rate of the cold water supplied to the cold-water type condenser by the cold-water volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

The sixth aspect is a further another mode showing a specific device configuration for preventing the condensation temperature of the cooling-medium gas in the cold-water type condenser from being varied even when the flow rate of the cooling-medium liquid supplied to the evaporator is subjected to valve control.

According to the sixth aspect of the present invention, even when the evaporation temperature of the evaporator is varied by subjecting the supply amount of the cooling-medium liquid supplied to the evaporator to valve control, the controller controls the cold-water flow rate for supplying the cold water to the cold-water type condenser, which is the low-pressure side of the cooling system, so that the temperature of the cooling-medium liquid at the outlet of the cold-water type condenser is not varied in conjunction with the variation.

Therefore, even when the flow rate of the cooling medium of the evaporator in the cooling system of the cooling-medium natural-circulation method is subjected to valve control, the natural circulation of the cooling medium can be stably maintained, and formation of dew on the surface of the evaporator can be prevented.

In a seventh aspect of the present invention according to the sixth aspect, the cooling-medium liquid temperature sensor is replaced by a cooling-medium liquid pressure sensor; and the controller controls the flow rate of the cold water of the cold-water supply piping by the cold-water volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

In the seventh aspect, instead of the temperature of the cooling-medium liquid at the outlet of the cold-water type condenser, the condensation pressure at the outlet of the cold-water type condenser is controlled so as to become the predetermined pressure.

In order to achieve the objects, an eighth aspect of the present invention provides a cooling system of circulating a cooling medium between an evaporator, which gasifies the cooling medium, and a condenser, which liquefies the cooling medium gasified by the evaporator, and using a cooling tower as the condenser, wherein the cooling tower has: a cooling-tower main body in which an intake opening and a discharge opening of outside air are formed; a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows; a sprinkler which sprinkles water to the heat-exchanging coil; an air blower which takes in the outside air from the intake opening, blows the air to the heat-exchanging coil, and causes the air to be discharged from the discharge opening; a circulation duct which returns part of discharge outside-air, which is discharged from the discharge opening, to a vicinity of the intake opening and mixes the returned outside-air with the outside air taken in from the intake opening; a circulated air-volume adjusting device which adjusts a circulated air-volume of the discharge outside-air flowing in the circulation duct; and a control mechanism which controls the circulated air-volume adjusting device so that a condensation pressure of the cooling-medium gas condensed by the heat-exchanging coil becomes a predetermined pressure.

According to the eighth aspect of the present invention, a conventional cooling tower utilizing outside air and water sprinkling is provided with the circulation duct, the circulated air-volume adjusting device, and the control mechanism. As a result, the outside air taken in from the intake opening of the cooling-tower main body evaporates the water sprinkled to the heat-exchanging coil and cools the cooling medium flowing in the heat-exchanging coil; meanwhile, the temperature of the outside air per se is increased, and the air is discharged from the discharge opening. When the part of the temperature-increased discharge outside-air is circulated by the circulation duct to the vicinity of the intake opening of the cooling-tower main body and mixed with the intake outside-air, the temperature of the blown outside-air blown to the heat-exchanging coil can be caused to be higher than the temperature of the outside air taken in from the intake opening. The degree of the increase can be controlled by adjusting the circulated air volume of the discharge outside-air flowing in the circulation duct by the circulated air-volume adjusting device.

When the condensation pressure for obtaining the liquid column in the liquid piping necessary for stable circulation of the cooling medium in the cooling system is the predetermined pressure, the control mechanism controls the temperature of the mixed outside-air so that the condensation pressure becomes the predetermined pressure. As a result, the condensation pressure can be prevented from being reduced more than necessity by the simple structural improvement of the cooling tower even during winter when the outside air temperature is low; therefore, reduction in the cooling ability of the evaporator can be prevented.

A ninth aspect of the present invention according to the eighth aspect, the control mechanism has a cooling-medium pressure sensor which measures a pressure of the cooling-medium gas at the inlet of the heat-exchanging coil; and a controller which controls the circulated air-volume adjusting device so that the pressure measured by the cooling-medium pressure sensor becomes the predetermined pressure.

In the ninth aspect, a mode of the control mechanism for controlling the condensation pressure to the predetermined pressure is shown. The cooling-medium gas at the inlet of the heat-exchanging coil is directly measured by the cooling-medium pressure sensor, and the controller controls the circulated air-volume adjusting device so that the measured pressure becomes the predetermined pressure.

As a result, the condensation pressure of the cooling-medium gas at the heat-exchanging coil can be controlled to the predetermined pressure.

In a tenth aspect of the present invention according to the eighth aspect, the control mechanism has a blown outside-air temperature sensor which measures a temperature of the blown outside-air blown to the heat-exchanging coil by the air blower; and a controller which has a set temperature of the blown outside-air for causing the condensation pressure of the cooling-medium gas condensed by the heat-exchanging coil to become the predetermined pressure, the set temperature input in advance, and controls the circulated air-volume adjusting device so that the temperature measured by the blown outside-air temperature sensor becomes the set temperature.

The tenth aspect shows another mode of the control mechanism for controlling the condensation pressure to the predetermined pressure. The blown outside-air temperature sensor measures the temperature of the blown outside-air, the set temperature of the blown outside-air for causing the pressure of the cooling-medium gas at the inlet of the heat exchanging coil to become the predetermined pressure is input to the controller in advance, and the controller controls the circulated air-volume adjusting device so that the temperature measured by the blown outside-air temperature sensor becomes the set temperature.

As a result, the condensation pressure of the cooling-medium gas at the heat-exchanging coil can be controlled to the predetermined pressure.

In an eleventh aspect of the present invention according to the eighth aspect, the control mechanism has a cooling-medium liquid temperature sensor which measures a temperature of the cooling-medium liquid at the outlet of the heat-exchanging coil; and a controller which has a set temperature of the cooling-medium liquid for causing the pressure of the cooling-medium gas at the inlet of the heat-exchanging coil to become the predetermined pressure, the set temperature input in advance, and controls the circulated air-volume adjusting device so that the temperature measured by the cooling-medium liquid temperature sensor becomes the set temperature.

The eleventh aspect shows further another mode of the control mechanism for controlling the condensation pressure to the predetermined pressure. The set temperature of the cooling-medium liquid for causing the cooling-medium liquid at the outlet of the heat-exchanging coil to achieve the predetermined pressure by the cooling-medium liquid temperature sensor is input to the controller in advance, and the controller controls the circulated air-volume adjusting device so that the temperature measured by the cooling-medium liquid temperature sensor becomes the set temperature.

As a result, the condensation pressure of the cooling-medium gas at the heat-exchanging coil can be controlled to the predetermined pressure.

As described above, according to the cooling method and the cooling system of the electronic device of the present invention, even when the flow rate of the cooling medium of the evaporator in the cooling system of the cooling-medium natural-circulation method is subjected to valve control, the natural circulation of the cooling medium can be stably maintained, and formation of dew on the surface of the evaporator can be prevented.

Moreover, according to the cooling system of the present invention, when the cooling tower serves as the condenser and the cooling medium is circulated, particularly, naturally circulated between the condenser and the evaporator, the condensation pressure can be prevented from being reduced more than necessity by the simple structural improvement of the cooling tower even during winter when the outside air temperature is low. As a result, reduction in the cooling ability of the evaporator can be prevented.

### BRIEF DESCRIPTION OF THE DRAWINGS

Fig. 1 is a schematic diagram explaining the overall constitution of a first embodiment of a cooling system of electronic devices of the present invention;
Fig. 2 is a schematic diagram explaining the overall constitution of a second embodiment of the cooling system of the electronic devices of the present invention;
Fig. 3 is an explanatory diagram explaining the structure of a cooling tower of a circulation duct type;
Fig. 4 is a schematic diagram explaining the overall constitution of a third embodiment of the cooling system of the electronic devices of the present invention;
Fig. 5 is a schematic diagram explaining the overall constitution of the cooling system of the present invention;
Fig. 6 is an explanatory diagram explaining the structure of a cooling tower and a mode of a control mechanism; and
Fig. 7 is an explanatory diagram explaining another mode of the control mechanism.

### DETAILED DESCRIPTION OF THE PREFERRED EMBODIMENTS

Hereinafter, preferred embodiments of a cooling method and a cooling system of electronic devices of the present invention will be described in detail with reference to appended drawings.

### [1] Embodiment A

In an embodiment A, a cooling method and a cooling system of electronic devices capable of stably maintaining natural circulation of a cooling medium and preventing formation of dew on the surfaces of evaporators even when the cooling-medium flow rate of the evaporators is subjected to valve control in the cooling system of the cooling-medium natural-circulation method will be explained. Examples in which servers disposed in server rooms serve as electronic devices will be explained.

### (First Embodiment)

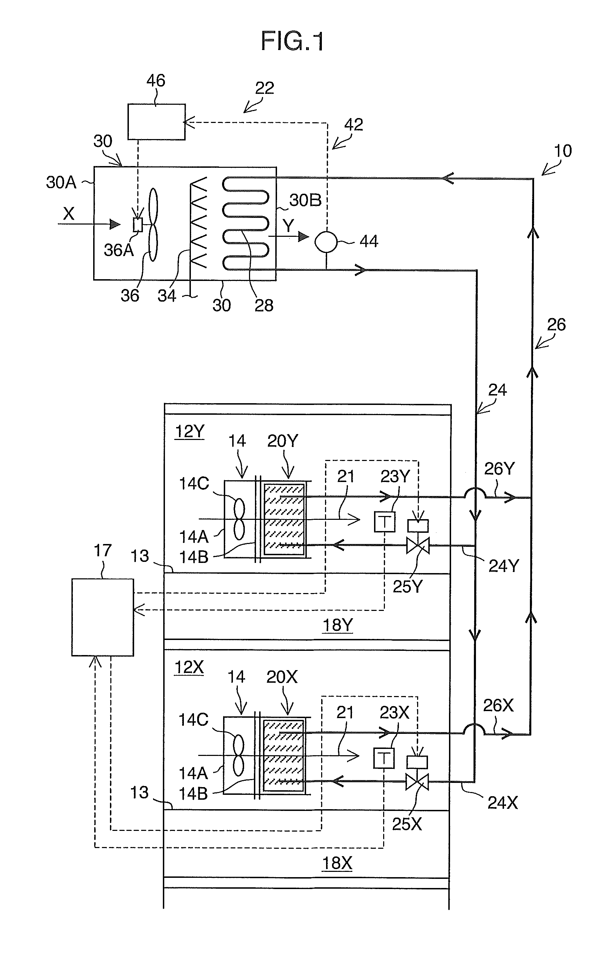

Fig. 1 is a schematic diagram showing the overall constitution of a first embodiment of a cooling system 10 of electronic devices.

The cooling system 10 shown in the diagram is a system, which locally cools the vicinities of servers 14 provided in server rooms 12X and 12Y in upper and lower two floors. Note that X appended to the reference numerals in the below description represents the members related to the cooling system of the lower floor, and Y represents the members related to the cooling system of the upper floor. In Fig. 1, one server 14 is shown.in each of the server rooms 12X and 12Y; however, in, practice, many servers 14 are disposed therein. Furthermore, usually, the servers 14 are installed in the server rooms 12X and 12Y in the manner in which the servers are stacked and housed in server racks (not shown).

Each of the servers 14 has a suction opening 14A and a discharge opening 14B for air and has a fan 14C in the interior thereof. When the fan 14C is driven, air is sucked in from the suction opening 14A, and heat-discharging air accompanied by the heat discharged from the server 14 is discharged from the discharge opening 14B. As a result, the server 14 can be cooled. Meanwhile, if the heat-discharging air is discharged to the server room 12X or 12Y without change, the room temperature of the server room 12X or 12Y is increased, and the temperature of the air sucked into the server 14 is increased. Therefore, the heat-discharging air has to be cooled by an evaporator 20X or 20Y before the air is discharged to the server room 12X or 12Y.

Underfloor chambers 18X and 18Y are formed under floor surfaces 13 of the server rooms 12X and 12Y, respectively. The underfloor chambers 18X and 18Y are communicated with the server rooms 12X and 12Y, respectively, via a plurality of outlets (not shown) formed on each of the floor surfaces 13. Moreover, a configuration of supplying air-conditioning air cooled by a package air conditioner or the like (not shown) to the underfloor chambers 18X and 18Y and blowing the air-conditioning air from the outlets to the server rooms 12X and 12Y may be added. In that case, the outlets are formed in the vicinity of the suction opening 14A of the server 14, and the server 14 can be efficiently cooled since the air-conditioning air is sucked into the server 14.

Furthermore, the server 14 is locally cooled by the cooling system 10.

The cooling system 10 constitutes a natural circulation cycle of a cooling medium, the cycle mainly composed of: the evaporators 20X and 20Y, a cooling tower 22 serving as a condenser, liquid piping 24 in which a cooling-medium liquid flows, and gas piping 26 in which a cooling-medium gas flows.

The evaporators 20X and 20Y are provided in the vicinities of the server discharge openings 14B, respectively; and coils, which are not shown, are provided in the evaporators 20X and 20Y. The heat-discharging air discharged from the server discharge openings 14B flows outside of the coils, and the cooling-medium liquid flows inside of the coils, thereby carrying out heat exchange. As a result, the cooling-medium liquid in the coils evaporates by absorbing vaporization heat from the heat-discharging air, thereby cooling the discharged air discharged to the server rooms 12X and 12Y. Thus, in combination with the air-conditioning air blown to the server rooms 12X and 12Y from the outlets, the temperature environments of the server rooms 12X and 12Y can be set to the temperature environments necessary for normally operating the servers 14.

The cooling tower 22 is a device which cools and condenses the cooling-medium gas, which has been gasified by the evaporators 20X and 20Y; and the cooling tower is provided at a higher position than the evaporators 20X and 20Y, for example, provided on the rooftop of a building of the server rooms 12.

The evaporators 20X and 20Y and the cooling tower 22 are mutually connected by the liquid piping 24 (including branch pipes 24X and 24Y) and the gas piping 26 (including branch pipes 26X and 26Y). An upper end of the gas piping 26 is connected to an inlet of a heat-exchanging coil 28 in the cooling tower 22, a lower end of the gas piping 26 is branched into the branch pipes 26X and 26Y, and the branch pipes 26X and 26Y are connected to ends of the coils (not shown) of the evaporators 20X and 20Y, respectively. On the other hand, an upper end of the liquid piping 24 is connected to an outlet of the heat-exchanging coil 28 in the cooling tower 22, a lower end of the liquid piping 24 is branched into the branch pipes 24X and 24Y, and the branch pipes 24X and 24Y are connected to the other ends of the coils (not shown) of the evaporators 20X and 20Y, respectively. Therefore, the cooling-medium gas gasified by the evaporators 20X and 20Y is moved up in the gas piping 26, naturally sent to the cooling tower 22, and liquefied by the cooling tower 22. Then, the liquefied cooling medium flows down through the liquid piping 24 and is naturally sent to the evaporators 20X and 20Y. Thus, the cooling medium is naturally circulated.

For example, chlorofluorocarbon or HFC (hydrofluorocarbon) serving as an alternative for chlorofluorocarbon can be used as the cooling medium circulated therein. If the cooling medium is to be used under a pressure lower than the atmospheric pressure, water can be also used.

When the supply amount of the cooling-medium liquid supplied to the evaporators 20X and 20Y is controlled, the temperature of the air obtained after the high-temperature air discharged from the servers 14 is cooled by the evaporators 20X and 20Y (the temperature of the discharged air discharged from the servers 14 to the server rooms 12X and 12Y via the evaporators 20X and 20Y) is cooled, and the server rooms 12X and 12Y are maintained to the temperature environments appropriate for the servers 14. More specifically, temperature sensors 23X and 23Y are provided respectively in the vicinities of the outlets of the discharged air 21 discharged from the evaporators 20X and 20Y to the server rooms 12X and 12Y; and flow-rate adjusting valves 25X and 25Y, which adjust the flow rate of the cooling-medium liquid, are provided respectively at the branch pipes 24X and 24Y of the liquid piping 24. The measured temperatures measured by the temperature sensors 23X and 23Y are input to a controller 17, and the controller 17 individually controls the open degree of the flow-rate adjusting valves 25X and 25Y based on the measured temperatures. Consequently, the cooling medium at the appropriate flow rates for achieving the same discharged-air temperature can be supplied to the evaporators 20X and 20Y of the upper floor and the lower floor at different heights. As a result, the temperatures of the discharged air discharged from the servers 14 to the server rooms 12X and 12Y via the evaporators 20X and 20Y can be adjusted to the temperature environments suitable for driving of the servers 14.

Next, the cooling tower 22 will be explained.

As shown in Fig. 1, in the cooling tower 22, a cooling-tower main body (casing) 30 is transversely disposed; an intake opening 30A, which takes in the outside air, is formed at one end side of the cooling-tower main body 30; and a discharge opening 30B of the outside air is formed in the other end side. The heat-exchanging coil 28 is provided in the cooling-tower main body 30, the inlet of the heat-exchanging coil 28 is connected to the gas piping 26 in which the cooling-medium gas returning from the evaporators 20X and 20Y flows, and an outlet of the heat-exchanging coil 28 is connected to the liquid piping 24 in which the cooling-medium liquid to be supplied to the evaporators 20X and 20Y flows.

In the intake opening 30A side with respect to the heat-exchanging coil 28, a sprinkler 34 is provided; and, furthermore, in the intake opening 30A side with respect to the sprinkler 34, an air-blower fan 36 is provided. The intake outside-air X taken in from the intake opening 30A of the cooling-tower main body 30 is blown to the heat-exchanging coil 28 by the air-blower fan 36, and water is sprinkled from the sprinkler 34 to the heat-exchanging coil 28. As a result, the cooling-medium gas flowing in the heat-exchanging coil 28 is cooled by the outside air and the sprinkled water, condensed, and liquefied into the cooling-medium liquid. Meanwhile, the intake outside-air X taken into the cooling-tower main body 30 absorbs heat from the cooling-medium gas flowing in the heat-exchanging coil 28 so as to increase the temperature thereof, and the outside air is discharged from the discharge opening 30B as discharge outside-air Y.

Moreover, in the cooling tower 22, a control mechanism 42 for maintaining the temperature of the cooling-medium liquid at the outlet of the heat-exchanging coil 28 constantly at a predetermined value is provided.

The control mechanism 42 is composed of: a cooling-medium liquid temperature sensor 44, which measures the temperature of the cooling-medium liquid at the outlet of the heat-exchanging coil 28; an air-blow volume adjusting device 36A, which adjusts the air-blow volume of the air blown from the air-blower fan 36 to the heat-exchanging coil 28; and a controller 46, which controls the air-blow volume adjusting device 36A based on the temperature measured by the cooling-medium liquid temperature sensor 44. The controller 46 may also serve as the controller 17; or, as shown in Fig. 1, the controller 46 for the cooling tower 22 may be separately provided. The case in which the controller is separately provided is explained in the present embodiment.

Next, function of the cooling system 10 of the electronic devices composed in the above described manner will be explained.

When the cooling-medium liquid is gasified by the evaporators 20X and 20Y, the high-temperature heat-discharging air from the servers 14 is cooled. Meanwhile, in the cooling tower 22, the cooling-medium gas from the evaporators 20X and 20Y is liquefied by cooling and condensing the gas, and the liquefied cooling-medium liquid flows down to the evaporators 20X and 20Y because of gravity. Thus, natural circulation of the cooling medium is formed. The controller 17 monitors the air temperatures measured by the temperature sensors 23X and 23Y, in other words, the temperatures of the air obtained after the heat-discharging air from the servers 14 is cooled by the evaporators 20X and 20Y; and the controller controls the flow-rate adjusting valves 25X and 25Y and adjusts the flow rate of the cooling-medium gas flowing in the liquid piping so that the temperature of the air becomes the temperature suitable for the operating environments of the servers 14. As a result of the valve control, the temperature of the air obtained after cooling at the evaporators 20X and 20Y is appropriately controlled.

However, since the valve control is an operation of adjusting the resistance of the liquid piping, the evaporation pressures in the evaporators 20X and 20Y are varied. Due to the variations in the evaporation pressures, there are problems that the natural circulation of the cooling medium becomes unstable, reduction in the evaporation temperatures is caused beyond needs, and significant reduction in the cooling-gas temperatures at the outlets of the evaporators 20X and 20Y is caused. Moreover, along with reduction in the evaporation temperatures, dew is formed on the surfaces of the evaporators 20X and 20Y, and there is a concern about adverse influence on the servers 14, which are precision machines.

Therefore, in the present invention, the condensation temperature of the cooling-medium gas in the cooling tower 22 is configured not to be varied even when the flow rates of the cooling-medium liquid supplied to the evaporators 20X and 20Y are subjected to valve control by the flow-rate adjusting valves 25X and 25Y.

More specifically, the controller 46 monitors whether the condensation temperature measured by the cooling-medium liquid temperature sensor 44 at the outlet of the heat-exchanging coil 28 is varied with respect to a predetermined temperature or not. Herein, the predetermined temperature is, for example, a condensation temperature necessary for stably carrying out natural circulation of the cooling medium.

When the measured temperature is varied with respect to the predetermined temperature, the controller 46 controls the air-blow volume adjusting device 36A of the cooling tower 22 so as to change the rotating speed of the air-blower fan 36 and adjusts the volume of the air blown to cool the heat-exchanging coil 28 so that the temperature measured by the cooling-medium liquid temperature sensor 44 becomes the predetermined temperature.

In this manner, in parallel with the valve control in the side of the evaporators 20X and 20Y, the condensation temperature of the cooling tower 22 side is controlled so that the temperature is not varied; as a result, the variations in the evaporation pressures of the side of the evaporators 20X and 20Y are suppressed. In other words, when the temperature variation in the cooling tower 22 side is eliminated, the pressure of the high-pressure side in the natural circulation of the cooling medium can be stably maintained, and the natural circulation of the cooling medium can be stabilized.

Therefore, even when the cooling-medium flow rates of the evaporators 20X and 20Y in the cooling system of the cooling-medium natural-circulation method are subjected to valve control, the natural circulation of the cooling medium can be stably maintained, and formation of dew on the surfaces of the evaporators can be prevented.

The degree of the variation in the measured temperature of the cooling-medium liquid temperature sensor 44 with respect to the predetermined temperature at which the controller 46 carries out control drive can be arbitrarily set. However, for example, the variation temperature is preferably set to within ? 1?C of a set temperature. The same applies to below-described modes of the present invention.

### (Second Embodiment)

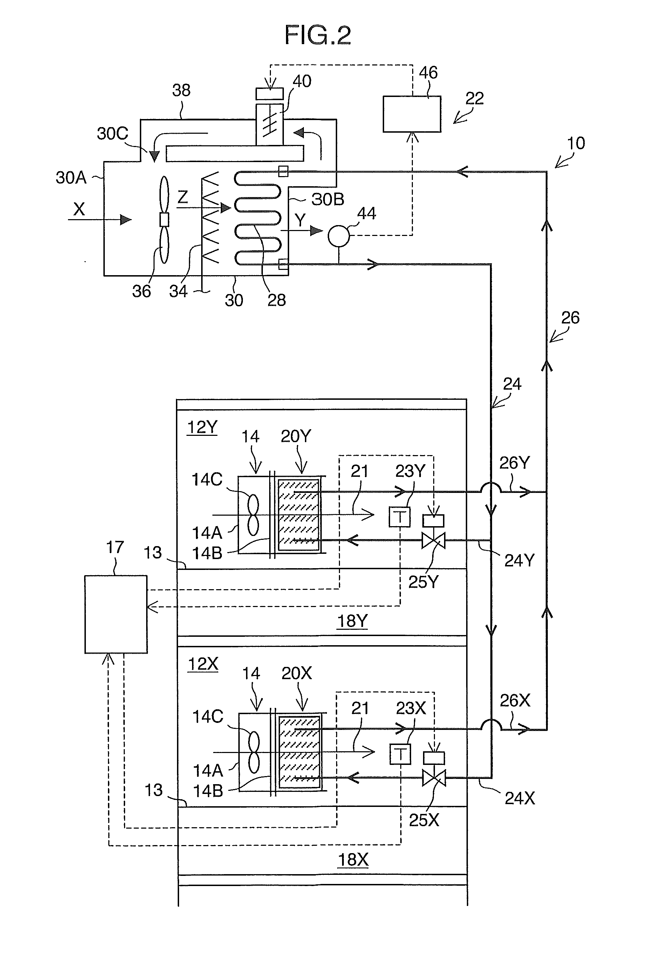

Fig. 2 is a schematic diagram showing the overall constitution of a second embodiment of the cooling system 10 of the electronic devices, which is a case in which a circulation duct type cooling tower is provided as a device which condenses the cooling-medium gas.

The parts common to those of the first embodiment are denoted by the same reference numerals, and explanations thereof will be omitted.

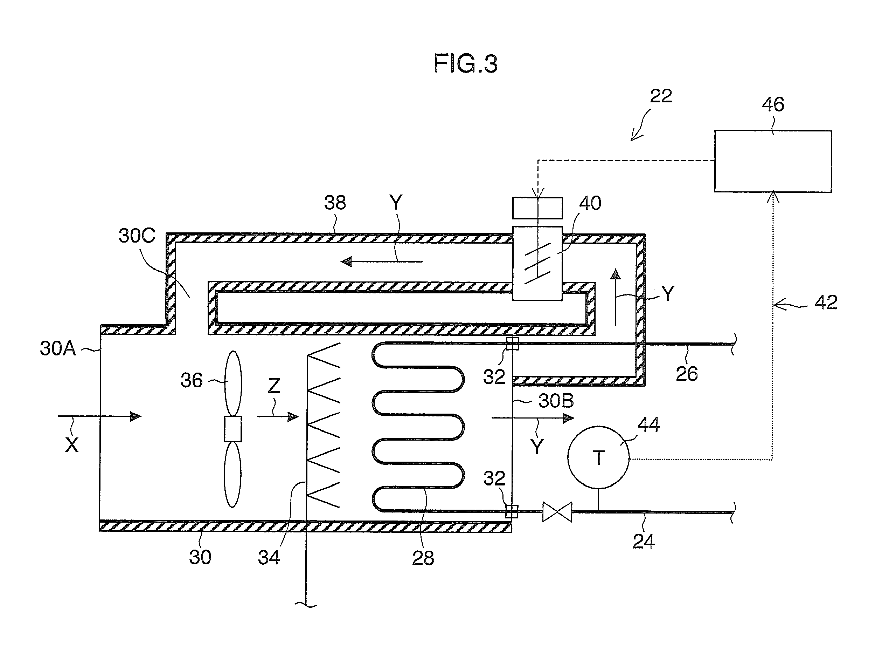

As shown in Fig. 2 and Fig. 3, a connecting hole 30C is bored in the intake opening 30A-side side surface of the cooling-tower main body 30, and part of the discharge opening 30B and the connecting hole 30C are mutually connected by a circulation duct 38. As a result, part of the temperature-increased discharge outside-air Y discharged from the discharge opening 30B is circulated to the vicinity of the intake opening 30A through the circulation duct 38; therefore, the discharge outside-air Y and the intake outside-air X is mixed with each other. As a result, the outside air temperature of the blown outside-air Z blown to the heat-exchanging coil 28 is increased by the air-blower fan 36.

In this case, it is preferred that the gas piping 26 which returns from the evaporators 20X and 20Y to the cooling tower 22 penetrate through a sidewall of the circulation duct 38 and be connected to the inlet of the heat-exchanging coil 28 through the interior of the circulation duct 38. As a result, part of the gas piping 26 is housed in the circulation duct 38. Therefore, heat exchange can be efficiently carried out between the discharge outside-air Y flowing in the circulation duct 38 and the cooling-medium gas flowing in the gas piping 26. Therefore, the heat quantity that the discharge outside-air Y absorbs from the heat-exchanging coil 28 can be increased; therefore, the discharge outside-air Y at a higher temperature than the discharge outside-air Y which is discharged from the discharge opening 30B can be mixed with the intake outside-air X.

Moreover, a damper device 40 (circulated air-volume adjusting device) is provided at an intermediate part of the circulation duct 38. When the open degree (including zero as the open degree) of the damper device 40 is adjusted, the mixed volume (including zero as the mixed volume) of the discharge outside-air Y mixed with the intake outside-air X is adjusted.

Furthermore, the cooling tower 22 is provided with the controller 46 which controls the air volume of the discharge outside-air Y flowing in the circulation duct 38 by the damper device 40 so that the condensation temperature of the cooling-medium gas condensed by the heat-exchanging coil 28 becomes a predetermined temperature. Herein, the predetermined temperature is, for example, a condensation temperature necessary for stably circulating the cooling medium between the evaporators 20X and 20Y and the cooling tower 22 in the cooling system of the present invention.

Based on the measured temperature from the cooling-medium liquid temperature sensor 44 provided at the outlet of the heat-exchanging coil 28, the controller 46 controls the open degree of the damper device 40 so that the temperature measured by the cooling-medium liquid temperature sensor 44 becomes the predetermined temperature.

Function of the second embodiment of the present invention constituted in the above described manner will be explained.

As described above, the three types of outside air, i.e., the intake outside-air X, the discharge outside-air Y, and the blown outside-air Z are mentioned, and usage thereof is separated in the below described manner. The intake outside-air X refers to the outside air which has not undergone change after the air is taken in from the intake opening 30A. The blown outside-air Z refers to the outside air blown to the heat-exchanging coil 28 by the air-blower fan 36 and includes both the intake outside-air X alone and the mixed outside-air of the intake outside-air X and the discharge outside-air Y. The discharge outside-air Y refers to the outside air having an increased temperature obtained after the blown outside-air Z undergoes contact and heat-exchange with the heat-exchanging coil 28.

Before operation of the cooling system 10 is started, the open degree of the damper device 40 is caused to be in the state of zero (closed state), and operation is started in this state. More specifically, the cooling-medium gas returning from the evaporators 20X and 20Y to the cooling tower 22 through the gas piping 26 flows in the heat-exchanging coil 28 in the cooling tower 22; and, at the same time, the cooling-medium gas is cooled and condensed by the intake outside-air X, which is taken-in from the intake opening 30A by the air-blower fan 36, and by the water sprinkled from the sprinkler 34. As a result, the cooling-medium gas is liquefied, becomes the cooling-medium liquid, flows in the liquid piping 24, and is supplied to the evaporators 20X and 20Y. Meanwhile, the blown outside-air Z brought into contact with the heat-exchanging coil 28 absorbs heat from the cooling-medium gas, increases the temperature thereof, becomes the discharge outside-air Y, and is discharged from the discharge opening 30B.

The cooling-medium liquid liquefied by the heat-exchanging coil 28 is measured at the outlet of the heat-exchanging coil 28 by the cooling-medium liquid temperature sensor 44, and the measured temperatures thereof are sequentially transmitted to the controller 46. If the measured temperature of the cooling-medium liquid is lower than the predetermined temperature, the controller 46 opens the damper device 40 so as to circulate part of the temperature-increased discharge outside-air Y to the vicinity of the intake opening 30A via the circulation duct 38 and mix the air with the intake outside-air X, and the controller 46 controls the air volume of the discharge outside-air Y, which flows in the circulation duct 38, by the open-degree control of the damper device 40 so that the measured temperature measured by the cooling-medium liquid temperature sensor 44 becomes the predetermined temperature.

If the temperature measured by the cooling-medium liquid temperature sensor 44 is varied with respect to the predetermined temperature, the controller 46 controls the damper device 40 of the circulation duct 38 formed in the cooling tower 22 to adjust the temperature of the blown outside-air blown to the heat-exchanging coil 28 so that the temperature measured by the cooling-medium liquid temperature sensor 44 becomes the predetermined temperature.

When the control is carried out in this manner in parallel with the valve control in the side of the evaporators 20X and 20Y so that the condensation temperature in the cooling tower 22 side is not varied, variations in the evaporation pressures of the side of the evaporators 20X and 20Y are suppressed. Therefore, temperature variations in the side of the cooling tower 22 of the circulation duct type are eliminated; as a result, the pressure of the high-pressure side in the natural circulation of the cooling medium can be stably maintained, and the natural circulation of the cooling medium can be stabilized.

Thus, even when the cooling-medium flow rates of the evaporators 20X and 20Y in the cooling system of the cooling-medium natural-circulation method are subjected to valve control, the natural circulation of the cooling medium can be stably maintained, and formation of dew on the surfaces of the evaporators can be prevented.

### [Third Embodiment of the Present Invention]

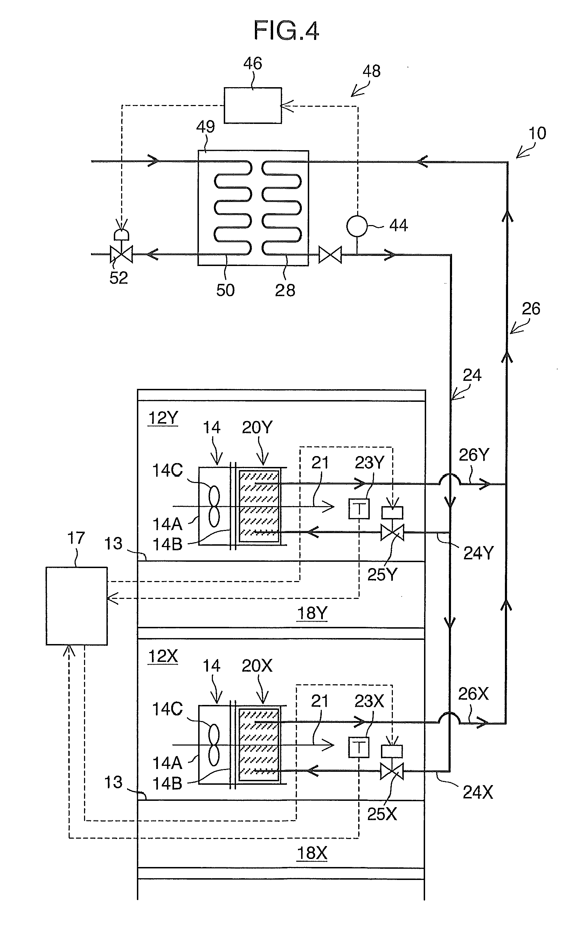

Fig. 4 is a schematic diagram showing the overall constitution of a third embodiment of the cooling system 10 of the electronic devices and shows the case in which the cooling tower 22 of the first and second embodiments is replaced by a cold-water-type condenser 48 as a device which condenses the cooling-medium gas.

The parts common to the first and second embodiments are denoted by the same reference numerals, and explanations thereof are omitted.

As shown in Fig. 4, in a cold-water-type condenser main body 49 (casing), the heat-exchanging coil 28, which is connected to the gas piping 26 and the liquid piping 24, and a cold-water supplying coil 50 connected to a cold-water supplying device, which is not shown, are provided. When the cooling-medium gas flowing in the heat-exchanging coil 28 and the cold water flowing in the cold-water supplying coil 50 exchange heat therebetween, the cooling-medium gas is cooled, condensed, and liquefied into the cooling-medium liquid.

Moreover, at the outlet of the heat-exchanging coil 28, the cooling-medium liquid temperature sensor 44, which measures the condensation temperature of the cooling medium condensed by the cold-water-type condenser 48 is provided; and, at the outlet of the cold-water supplying coil 50, a cold-water volume adjusting valve 52, which adjusts the flow rate of the cold water which flows in the cold-water supplying coil 50, is provided.

The cooling-medium temperature measured by the cooling-medium liquid temperature sensor 44 is sequentially input to the controller 46 and subjected to monitoring whether the cooling-medium temperature is varied with respect to the predetermined temperature or not. Furthermore, the controller 46 controls the flow rate of the cold water, which is supplied to the cold-water-type condenser 48, by the cold-water volume adjusting valve 52 so that the temperature measured by the cooling-medium liquid temperature sensor 44 is maintained at the predetermined temperature without being varied in conjunction with the variations in the evaporation temperatures of the evaporators 20X and 20Y caused by valve control in the side of the evaporators 20X and 20Y.

Thus, also in the case of the third embodiment of the present invention, even when the cooling-medium flow rates of the evaporators 20X and 20Y in the cooling system of the cooling-medium natural-circulation method are subjected to valve control, natural circulation of the cooling medium can be stably maintained, and formation of dew on the surfaces of the evaporators can be prevented.

In the first embodiment to the third embodiment, the temperature sensor is disposed at the outlet of the heat-exchanging coil 28 of the cooling tower 22 (including the circulation duct type) or the cold-water-type condenser 48; however, alternatively, a pressure sensor (not shown) may be disposed, and the controller 46 may carry out control so that the pressure measured by the pressure sensor is maintained at a predetermined pressure without being varied in conjunction with the variations in the evaporation temperatures of the evaporators 20X and 20Y caused by the valve control in the side of the evaporators 20X and 20Y. Herein, the predetermined pressure is, for example, a condensation pressure necessary for stably carrying out natural circulation of the cooling medium.

### [2] Embodiment B

In an embodiment B, a cooling system will be explained, the cooling system capable of preventing reduction in the cooling ability of evaporators by preventing the condensation pressure from being reduced more than necessity by simple structural improvement of a cooling tower even during the winter when the outside air temperature is low, in the case in which the cooling tower serves as a condenser and a cooling medium is circulated, particularly, naturally circulated between the condenser and the evaporators. The devices and members same as those of the embodiment A will be explained with the denotation by the same reference numerals. The cooling system of the present invention is not limited to the cooling-medium natural-circulation method in which the cooling medium is naturally circulated; however, the present embodiment will be explained by an example of the cooling-medium natural-circulation method.

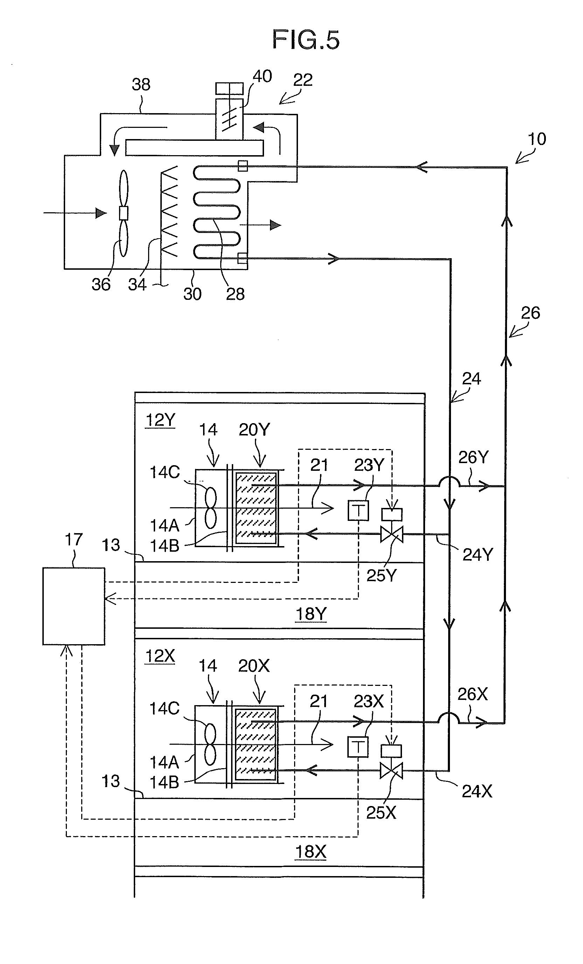

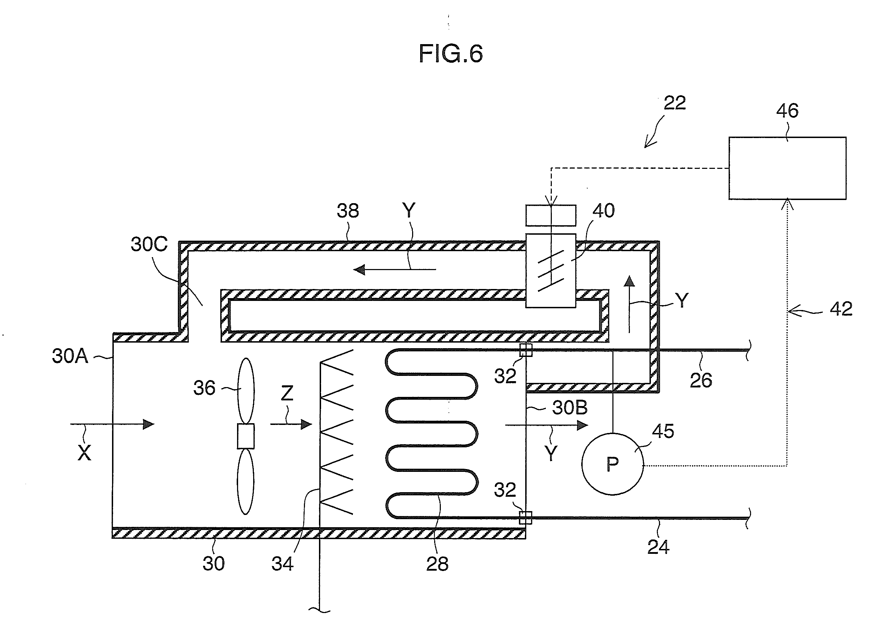

Fig. 5 is a schematic diagram showing the overall constitution of the cooling system 10 of the electronic devices, wherein the constitution is same as the constitution shown in Fig. 1 except part of the structure of the cooling tower 22; and the constitution of the cooling tower 22 of Fig. 6 is approximately same as that of Fig. 3, which is a mode of the embodiment A.

Therefore, explanations about Fig. 5 of the overall constitution will be omitted, and explanations of redundant part of Fig. 6 will be also omitted.

The cooling tower 22 of Fig. 6 is provided with the control mechanism 42, which controls the air volume of the discharge outside-air Y flowing in the circulation duct 38, by the damper device 40 so that the condensation pressure of the cooling-medium gas condensed by the heat-exchanging coil 28 becomes a predetermined pressure. Herein, the predetermined pressure is, for example, a condensation pressure for obtaining a liquid column necessary for stably circulating the cooling medium between the evaporators 20X and 20Y and the cooling tower 22 in the cooling system of the present invention.

The control mechanism 42 can be composed of a cooling-medium pressure sensor 45, which measures the pressure of the cooling-medium gas at the inlet of the heat-exchanging coil 28, and the controller 46, which controls the damper device 40 so that the pressure measured by the cooling-medium pressure sensor 45 becomes the predetermined pressure. The controller 46 may also serve as the controller 17 shown in Fig. 1; or, as shown in Fig. 6, the controller 46 for the cooling tower 22 may be separately provided. The case in which the controller is separately provided is explained in the present embodiment.

Next, working of the cooling tower 22 in the cooling system constituted in the above described manner will be explained.

The intake outside-air X, the discharge outside-air Y, and the blown outside-air Z are same as those explained for Fig. 3.

Before operation of the cooling system 10 is started, the open degree of the damper device 40 is caused to be in the state of zero (closed state), and operation is started in this state. More specifically, the cooling-medium gas returning from the evaporators 20X and 20Y to the cooling tower 22 through the gas piping 26 flows in the heat-exchanging coil 28 in the cooling tower 22; and, at the same time, the cooling-medium gas is cooled and condensed by the intake outside-air X, which is taken-in from the intake opening 30A by the air-blower fan 36, and by the water sprinkled from the sprinkler 34. As a result, the cooling-medium gas is liquefied, becomes the cooling-medium liquid, flows in the liquid piping 24, and is supplied to the evaporators 20X and 20Y. Meanwhile, the blown outside-air Z brought into contact with the heat-exchanging coil 28 absorbs heat from the cooling-medium gas, increases the temperature thereof, becomes the discharge outside-air Y, and is discharged from the discharge opening 30B.

The cooling-medium gas in the heat-exchanging coil 28 is measured at the inlet of the heat-exchanging coil 28 by the cooling-medium pressure sensor 45, and the measured pressures thereof are sequentially transmitted to the controller 46. If the measured pressure of the cooling-medium gas is lower than the predetermined pressure, the controller 46 opens the damper device 40 so as to circulate part of the temperature-increased discharge outside-air Y to the vicinity of the intake opening 30A via the circulation duct 38 and mix the air with the intake outside-air X, and the controller 46 controls the air volume of the discharge outside-air Y, which flows in the circulation duct 38, by the open-degree control of the damper device 40 so that the measured pressure measured by the cooling-medium pressure sensor 45 becomes the predetermined pressure. If the measured pressure of the cooling-medium gas is desired to be largely increased, the open degree of the damper device 40 is largely increased; and, if the pressure is desired to be moderately increased, the open degree of the damper device 40 is caused to be moderate.

As a result, the condensation pressure in the cooling tower 22 can be prevented from being reduced more than necessity by simple structural improvement of the cooling tower 22 even during winter when the outside air temperature is low. Therefore, reduction in the cooling abilities of the evaporators 20X and 20Y can be prevented.

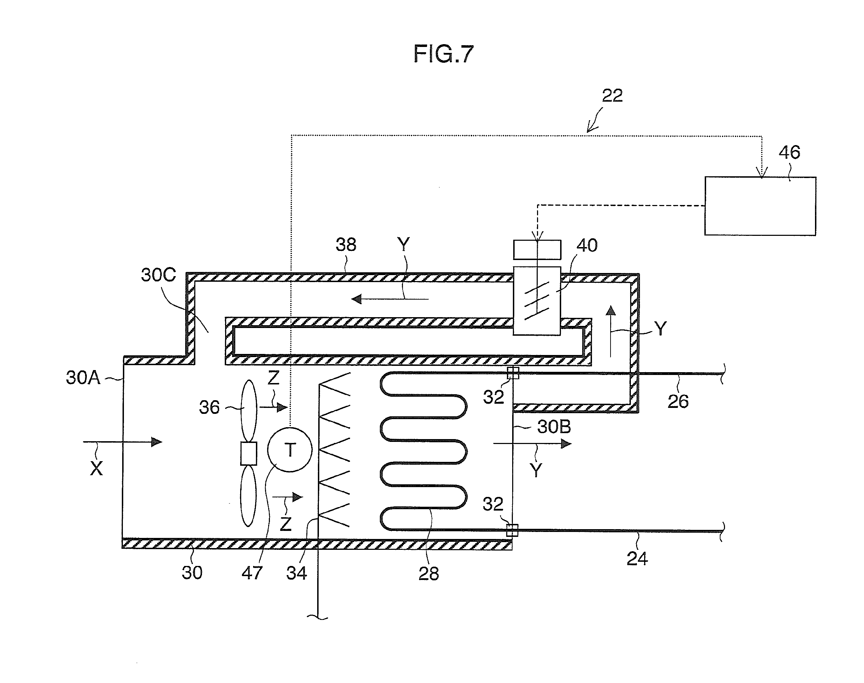

Fig. 7 shows another mode of the control mechanism 42. The members and devices same as those of Fig. 6 will be explained with the denotation by the same reference numerals.

As shown in Fig. 7, a blown outside-air temperature sensor 47, which measures the temperature of the blown outside-air Z obtained after the intake outside-air X is mixed with the discharge outside-air Y, is provided. In the controller 46, correlation data of the predetermined pressure of the cooling-medium gas at the inlet of the heat-exchanging coil 28 and the set temperature of the blown outside-air Z, in other words, the data of the correlation that at which temperature of the blown outside-air Z the predetermined pressure of the cooling-medium gas is obtained, is input in advance. The correlation data can be generated and obtained, for example, by preliminary tests.

Based on the correlation data, the controller 46 controls the open degree of the damper device 40 so that the temperature measured by the blown outside-air temperature sensor 47 becomes the set temperature.

As a result, the condensation pressure in the cooling tower 22 can be prevented from being reduced more than necessity by simple structural improvement of the cooling tower 22 even during winter when the outside air temperature is low. Therefore, reduction in the cooling abilities of the evaporators 20X and 20Y can be prevented.

As further another mode of the control mechanism 42 which controls the air volume of the discharge outside-air Y, which flows in the circulation duct 38, by the damper device 40, the constitution already explained by Fig. 3 can be used.

As shown in Fig. 3, the cooling-medium liquid temperature sensor 44 which measures the temperature of the cooling-medium liquid, which is liquefied by the heat-exchanging coil 28, is provided at the outlet of the heat-exchanging coil 28, and the measured temperatures thereof are sequentially transmitted to the controller 46. In the controller 46, the correlation data of the pressures and the temperatures of the cooling medium is input in advance. For example, a refrigeration and air-conditioning handbook may be used as a reference for the correlation data. Based on the correlation data, the controller 46 controls the open degree of the damper device 40 so that the temperature measured by the cooling-medium liquid temperature sensor 44 becomes the set temperature.

As a result, even during winter when the outside air temperature is low, the condensation pressure in the cooling tower 22 can be prevented from being reduced more than necessity by simple structural improvement of the cooling tower 22; therefore, reduction in the cooling abilities of the evaporators 20X and 20Y can be prevented.

The control mechanism 42 of Fig. 3 and Fig. 7 indirectly controls the pressure of the cooling-medium gas at the inlet of the heat-exchanging coil 28, which is desired to be controlled to the predetermined pressure, by measuring the temperature of the blown outside-air or the temperature of the cooling-medium liquid.

In the embodiments, the examples of the cooling system 10 in which the cooling medium is naturally circulated have been explained; however, the embodiments can be also applied to a cooling system in which the cooling medium is forcibly circulated. The objects to be cooled by the evaporators 20X and 20Y are not limited to electronic devices such as servers, and heating elements that require cooling can be applied.

## Claims

1. A cooling method of an electronic device (14), the cooling method naturally circulating a cooling medium between an evaporator (20X, 20Y), which gasifies the cooling medium and cools heat-discharging air from the electronic device by heat exchange with the heat-discharging air, and a cooling tower (30) or a condenser (22), which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, **characterized in that**
a condensation temperature or a condensation pressure of the cooling-medium gas in the cooling tower or the condenser is configured to be not varied even when the flow rate of the cooling-medium liquid supplied to the evaporator is subjected to the valve control.

2. A cooling system of an electronic device, the cooling system naturally circulating a cooling medium between an evaporator, which gasifies the cooling medium and cools heat-discharging air from the electronic device by heat exchange with the heat-discharging air, and a cooling tower, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, **characterized in that**
the cooling tower has:
a cooling-tower main body in which an intake opening and a discharge opening of outside air are formed;
a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows;
a sprinkler which sprinkles water to the heat-exchanging coil;
an air blower which takes in the outside air from the intake opening, blows the air to the heat-exchanging coil, and causes the air to be discharged from the discharge opening;
an air-blow volume adjusting device which adjusts an air-blow volume of the air blower;
a cooling-medium liquid temperature sensor which measures a temperature of the cooling-medium liquid at the outlet of the heat-exchanging coil; and
a controller which controls the air-blow volume adjusting device based on the temperature measured by the cooling-medium liquid temperature sensor; and
the controller controls the air-blow volume of the air blower by the air-blow volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

3. The cooling system of the electronic device according to claim 2, wherein
the cooling-medium liquid temperature sensor is replaced by a cooling-medium liquid pressure sensor; and
the controller controls the air-blow volume of the air blower by the air-blow volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

4. A cooling system of an electronic device, the cooling system naturally circulating a cooling medium between an evaporator, which gasifies the cooling medium and cools heat-discharging air from the electronic device by heat exchange with the heat-discharging air, and a cooling tower, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, **characterized in that**
the cooling tower has:
a cooling-tower main body in which an intake opening and a discharge opening of outside air are formed;
a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows;
a sprinkler which sprinkles water to the heat-exchanging coil;
an air blower which takes in the outside air from the intake opening, blows the air to the heat-exchanging coil, and causes the air to be discharged from the discharge opening;
a cooling-medium liquid temperature sensor which measures a temperature of the cooling-medium liquid at the outlet of the heat-exchanging coil;
a circulation duct which returns part of discharge outside-air, which is discharged from the discharge opening, to a vicinity of the intake opening and mixes the returned outside-air with the outside air taken in from the intake opening;
a circulated air-volume adjusting device which adjusts an air volume of the discharge outside-air flowing in the circulation duct; and
a controller which controls the circulated air-volume adjusting device based on the temperature measured by the cooling-medium liquid temperature sensor; and
the controller controls the circulated air-volume of the discharge outside-air flowing in the circulation duct by the circulated air-volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

5. The cooling system of the electronic device according to claim 4, wherein
the cooling-medium liquid temperature sensor is replaced by a cooling-medium liquid pressure sensor; and
the controller controls the circulated air-volume of the discharge outside-air flowing in the circulation duct by the circulated air-volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

6. A cooling system of an electronic device, the cooling system naturally circulating a cooling medium between an evaporator, which gasifies the cooling medium and cools heat-discharging air from the electronic device by heat exchange with the heat-discharging air, and a cold-water type condenser, which is disposed at a higher position than the evaporator and liquefies the gasified cooling medium, and subjecting a flow rate of the cooling-medium liquid supplied to the evaporator to valve control so that a temperature of the air obtained after the heat exchange and the cooling by the evaporator becomes a temperature suitable for an operating environment of the electronic device, **characterized in that**
the cold-water type condenser is
a condenser which has an inlet and an outlet and obtains cold energy for condensing the cooling-medium gas into the cooling-medium liquid by cold water supplied to the cold-water type condenser via cold-water supply piping, the inlet connected to gas piping in which the cooling-medium gas returning from the evaporator flows, the outlet connected to liquid piping in which the cooling-medium liquid supplied to the evaporator flows;
the condenser having
a cold-water volume adjusting device which is provided at the cold-water supply piping and adjusts a flow rate of the cold water supplied to the cold-water type condenser;
a cooling-medium liquid temperature sensor which measures a temperature of the cooling-medium liquid at the outlet of the cold-water type condenser; and
a controller which controls the cold-water volume adjusting device based on the temperature measured by the cooling-medium liquid temperature sensor; and
the controller controls the flow rate of the cold water supplied to the cold-water type.condenser by the cold-water volume adjusting device so that the temperature measured by the cooling-medium liquid temperature sensor is maintained at a predetermined temperature without being varied in conjunction with variation in an evaporation temperature of the evaporator, the variation caused by the valve control in the side of the evaporator.

7. The cooling system of the electronic device according to claim 6, wherein
the cooling-medium liquid temperature sensor is replaced by a cooling-medium liquid pressure sensor; and
the controller controls the flow rate of the cold water of the cold-water supply piping by the cold-water volume adjusting device so that a pressure measured by the cooling-medium liquid pressure sensor is maintained at a predetermined pressure without being varied in conjunction with variation in the evaporation temperature of the evaporator, the variation caused by the valve control in the side of the evaporator.

8. A cooling system circulating a cooling medium between an evaporator, which gasifies the cooling medium, and a condenser, which liquefies the cooling medium gasified by the evaporator, and using a cooling tower as the condenser, **characterized in that**
the cooling tower has:
a cooling-tower main body in which an intake opening and a discharge opening of outside air are formed;
a heat-exchanging coil which is provided in the cooling-tower main body and has an inlet and an outlet, the inlet connected to gas piping in which the cooling-medium gas returning from the evaporator flows, the outlet connected to liquid piping in which the cooling-medium liquid supplied to the evaporator flows;
a sprinkler which sprinkles water to the heat-exchanging coil;
an air blower which takes in the outside air from the intake opening, blows the air to the heat-exchanging coil, and causes the air to be discharged from the discharge opening;
a circulation duct which returns part of discharge outside-air, which is discharged from the discharge opening, to a vicinity of the intake opening and mixes the returned outside-air with the outside air taken in from the intake opening;
a circulated air-volume adjusting device which adjusts a circulated air-volume of the discharge outside-air flowing in the circulation duct; and
a control mechanism which controls the circulated air-volume adjusting device so that a condensation pressure of the cooling-medium gas condensed by the heat-exchanging coil becomes a predetermined pressure.

9. The cooling system according to claim 8, wherein
the control mechanism has
a cooling-medium pressure sensor which measures a pressure of the cooling-medium gas at the inlet of the heat-exchanging coil; and
a controller which controls the circulated air-volume adjusting device so that the pressure measured by the cooling-medium pressure sensor becomes the predetermined pressure.

10. The cooling system according to claim 8, wherein
the control mechanism has
a blown outside-air temperature sensor which measures a temperature of the blown outside-air blown to the heat-exchanging coil by the air blower; and
a controller which has a set temperature of the blown outside-air for causing the condensation pressure of the cooling-medium gas condensed by the heat-exchanging coil to become the predetermined pressure, the set temperature input in advance, and controls the circulated air-volume adjusting device so that the temperature measured by the blown outside-air temperature sensor becomes the set temperature.

11. The cooling system according to claim 8, wherein
the control mechanism has
a cooling-medium liquid temperature sensor which measures a temperature of the cooling-medium liquid at the outlet of the heat-exchanging coil; and
a controller which has a set temperature of the cooling-medium liquid for causing the pressure of the cooling-medium gas at the inlet of the heat-exchanging coil to become the predetermined pressure, the set temperature input in advance, and controls the circulated air-volume adjusting device so that the temperature measured by the cooling-medium liquid temperature sensor becomes the set temperature.
